# EUROPEAN PATENT APPLICATION

(11) **EP 4 841 274 A1**
(43) Date of publication of application: **18.11.2026**
(21) Application number: 26173729.0
(22) Date of filing: 21.04.2026
(51) Int. Cl.: G01R 31/34, H02P 29/024, G01R 31/52

(54) **SYSTEMS AND METHODS FOR DETECTION OF INTER-TURN SHORT CIRCUIT FAULT IN INDUCTION MOTORS**

(30) Priority: 12.05.2025 US 202519205708
(71) Applicant: ABB Schweiz AG, 5400 Baden (CH)
(72) Inventor: GONG, Huangjie, Raleigh, 27606 (US); CHOOBINEH, Moein, Raleigh, 27606 (US); FADDEL MOHAMED, Samy Gamal, Raleigh, 27606 (US)
(74) Representative: Zimmermann & Partner Patentanwälte mbB

(57) **Abstract**

A system for inter-turn short circuit fault detection can comprise one or more processors and a memory storing computer instructions. The one or more processors and the memory can cause the system to acquire, over a time period, a plurality of measurements of three-phase current input to a motor, transform, using Park transformation, the plurality of measurements of the three-phase current to a plurality of phasors in a two-dimensional space, each measurement of the three-phase current transformed into a corresponding phasor having two-dimensional coordinates in the two-dimensional space, determine an elongation of a shape defined by the plurality of phasors in the two-dimensional space and determine, using the elongation of the shape defined by the plurality of phasors in the two-dimensional space, whether the motor suffers from an inter-turn short circuit fault.

## Description

### TECHNICAL FIELD

The field of the disclosure relates to detection and classification of various faults for induction or asynchronous motors and, in particular, to systems and methods for detection of inter-turn short circuit faults.

### BACKGROUND

Induction motors, also known as asynchronous motors, are electric motors driven by alternate current (AC). The stator of an induction motor produces a rotating magnetic field when supplied with AC current. In particular, the stator includes windings or wire coils that produce the rotating magnetic field when supplied with the AC current. The rotating magnetic field interacts with the rotor of the induction motor by creating a torque causing the rotor to rotate and generate mechanical energy. Due to their simplicity, durability, and reliability, induction motors are widely used in various devices or systems, such as fans, pumps, compressors, industrial machinery, household appliances and electric vehicles among others.

One of the faults frequently experienced by induction motors is inter-turn short circuit. Break down or wear down of insulation between adjacent turns or loops of the same coil of the stator leads to direct electrical connection between the adjacent turns or loops resulting in an inter-turn short circuit and a low-impedance path. Relatively large current often flows through the short circuit and generates excessive heat, which can potentially melt the insulation of neighboring turns or loops and/or damage the entire coil or winding. The inter-turn short circuit can lead to magnetic field asymmetry, vibrations, higher harmonics in the torque waveform and/or motor failure.

Embodiments described herein provide novel and improved systems and methods for detecting inter-turn short circuit faults in induction motors.

### SUMMARY

According to one aspect, a system for inter-turn short circuit fault detection can comprise one or more processors and a memory storing computer instructions. The computer instructions, when executed by the one or more processors, can cause the one or more processors to acquire, over a time period, a plurality of measurements of three-phase current input to a motor, transform, using Park transformation, the plurality of measurements of the three-phase current to a plurality of phasors in a two-dimensional space, each measurement of the three-phase current transformed into a corresponding phasor having two-dimensional coordinates in the two-dimensional space, determine an elongation of a shape defined by the plurality of phasors in the two-dimensional space, the elongation of the shape representing a degree to which the shape is stretched in one direction compared to another, and determine, using the elongation of the shape defined by the plurality of phasors in the two-dimensional space, whether the motor suffers from an inter-turn short circuit fault.

In some implementations, to determine the elongation the one or more processors can be configured to determine a longest dimension of the shape defined by the plurality of phasors in the two-dimensional space, determine a shortest dimension of the shape defined by the plurality of phasors in the two-dimensional space, and compute the elongation as a ratio of the longest dimension to the shortest dimension.

The one or more processors can be configured to detect that the motor suffers from the inter-turn short circuit fault upon determining that the ratio of the longest dimension to the shortest dimension exceeds a threshold value.

In some implementations, the one or more processors can be configured to divide the shape defined by the plurality of phasors in the two-dimensional space into a plurality of angular sectors, determine, for each angular sector of the plurality of angular sectors, a representative phasor of the angular sector, arrange the representative phasors into pairs, each pair of representative phasors corresponding to a pair of diagonally opposite angular sectors, determine, for each pair of representative phasors, a distance between endpoints of the pair of representative phasors, determine, among all pairs of representative phasors, a first pair of representative phasors with a shortest distance between respective endpoints and a second pair of representative phasors with a longest distance between respective endpoints, and determine the elongation as a ratio of the longest distance to the shortest distance.

The one or more processors can be configured to determine that the motor suffers from the inter-turn short circuit fault upon determining that the ratio of the longest distance to the shortest distance exceeds a threshold value.

The one or more processors can be configured to determine, for each angular sector, the representative phasor of the angular sector as an average phasor of the angular sector, a median phasor of the angular sector, a maximum phasor of the angular sector, or a minimum phasor of the angular sector.

The one or more processors can be configured to determine, for each angular sector, a first phasor having a largest magnitude in the angular sector and a second phasor having a smallest magnitude in the angular sector, and determine the representative phasor of the angular sector as an average of the first phasor and the second phasor.

The one or more processors can be configured to acquire, over a second time period, a second plurality of measurements of three-phase current input to the motor, transform, using the Park transformation, the second plurality of measurements of the three-phase current to a second plurality of phasors in the two-dimensional space, determine a second elongation of a second shape defined by the second plurality of phasors in the two-dimensional space, and determine, using the second elongation of the second shape defined by the second plurality of phasors in the two-dimensional space, whether the motor suffers from the inter-turn short circuit fault.

The one or more processors can be configured, upon determining that the motor suffers from the inter-turn short circuit fault, to perform at least one of: output an alert signal indicative of the inter-turn short circuit fault; switch off the motor; or actuate one or more processes to further check for the inter-turn short circuit fault.

The one or more processors can be configured to employ a trained machine learning model to determine whether the motor suffers from an inter-turn short circuit fault. The trained machine learning model can be configured to receive the elongation as input and provide as output an indication of whether the whether the motor suffers from an inter-turn short circuit fault.

According to another aspect, a method for inter-turn short circuit fault detection can comprise acquiring, over a time period, a plurality of measurements of three-phase current input to a motor, transforming, using Park transformation, the plurality of measurements of the three-phase current to a plurality of phasors in a two-dimensional space, each measurement of the three-phase current transformed into a corresponding phasor having two-dimensional coordinates in the two-dimensional space, determining an elongation of a shape defined by the plurality of phasors in the two-dimensional space, the elongation of the shape representing a degree to which the shape is stretched in one direction compared to another, and determining, using the elongation of the shape defined by the plurality of phasors in the two-dimensional space, whether the motor suffers from an inter-turn short circuit fault.

In some implementations, determining the elongation can include determining a longest dimension of the shape defined by the plurality of phasors in the two-dimensional space, determining a shortest dimension of the shape defined by the plurality of phasors in the two-dimensional space, and computing the elongation as a ratio of the longest dimension to the shortest dimension.

The method can include detecting that the motor suffers from the inter-turn short circuit fault upon determining that the ratio of the longest dimension to the shortest dimension exceeds a threshold value.

The method can include dividing the shape defined by the plurality of phasors in the two-dimensional space into a plurality of angular sectors, determining, for each angular sector of the plurality of angular sectors, a representative phasor of the angular sector, arranging the representative phasors into pairs, each pair of representative phasors corresponding to a pair of diagonally opposite angular sectors, determining, for each pair of representative phasors, a distance between endpoints between the pair of representative phasors, determining, among all pairs of representative phasors, a first pair of representative phasors with a shortest distance between respective endpoints and a second pair of representative phasors with a longest distance between respective endpoints, and determining the elongation as a ratio of the longest distance to the shortest distance.

The method can include determining that the motor suffers from the inter-turn short circuit fault upon determining that the ratio of the longest distance to the shortest distance exceeds a threshold value.

The method can include determining, for each angular sector, the representative phasor of the angular sector as an average phasor of the angular sector, a median phasor of the angular sector, a maximum phasor of the angular sector, or a minimum phasor of the angular sector.

The method can include comprising determining, for each angular sector, a first phasor having a largest magnitude in the angular sector and a second phasor having a smallest magnitude in the angular sector, and determining the representative phasor of the angular sector as an average of the first phasor and the second phasor.

The method can include acquiring, over a second time period, a second plurality of measurements of three-phase current input to the motor, transforming, using the Park transformation, the second plurality of measurements of the three-phase current to a second plurality of phasors in the two-dimensional space, determining a second elongation of a second shape defined by the second plurality of phasors in the two-dimensional space, and determining, using the second elongation of the second shape defined by the second plurality of phasors in the two-dimensional space, whether the motor suffers from the inter-turn short circuit fault.

The method can include, upon determining that the motor suffers from the inter-turn short circuit fault, performing at least one of outputting an alert signal indicative of the inter-turn short circuit fault, switching off the motor, or actuating one or more processes to further check for the inter-turn short circuit fault.

The method can include employing a trained machine learning model to determine whether the motor suffers from an inter-turn short circuit fault. The trained machine learning model can be configured to receive the elongation as input and provide as output an indication of whether the whether the motor suffers from an inter-turn short circuit fault.

Various refinements exist of the features noted in relation to the above-mentioned aspects. Further features may also be incorporated in the above-mentioned aspects as well. These refinements and additional features may exist individually or in any combination. For instance, various features discussed below in relation to any of the illustrated examples may be incorporated into any of the above-described aspects, alone or in any combination.

### BRIEF DESCRIPTION OF DRAWINGS

The following drawings form part of the present specification and are included to further demonstrate certain aspects of the present disclosure. The disclosure may be better understood by reference to one or more of these drawings in combination with the detailed description of specific embodiments presented herein.
FIG. 1 is a block diagram of a computer environment for inter-turn short circuit fault detection, according to an example embodiment of the current disclosure.
FIG. 2 is a flow chart of a method for inter-turn short circuit fault detection, according to an example embodiment of the current disclosure.
FIG. 3 is a diagram illustrating a fault detection cycle, according to an example embodiment of the current disclosure.
FIG. 4. Illustrates vectors for three sampled points in the alpha-beta coordinate system, according to an example embodiment of the current disclosure.
FIG. 5 is a diagram illustrating an example Park circle defined by phasors determined or computed using three-phase current measurements acquired during a corresponding time interval or fault detection cycle, according to an example embodiment of the current disclosure.
FIG. 6 illustrates an angular sector of the Park circle and end points of phasors therein, according to an example embodiment of the current disclosure.
FIG. 7 illustrates selection of a representative phasor of the angular sector in FIG. 6, according to an example embodiment of the current disclosure.
FIG. 8 illustrates the angular sector of FIG. 6 and a corresponding opposite angular sector, according to an example embodiment of the current disclosure.
FIG. 9 illustrates a representative phasor for a first angular sector and the corresponding pairing phasor in a second angular sector opposite to the first angular sector, according to an example embodiment of the current disclosure.
FIG. 10 illustrates an example stretched Park circle and corresponding longest and shortest dimensions, according to an example embodiment of the current disclosure.

Corresponding reference characters indicate corresponding parts throughout the several views of the drawings. Although specific features of various examples may be shown in some drawings and not in others, this is for convenience only. Any feature of any drawing may be referenced or claimed in combination with any feature of any other drawing.

### DETAILED DESCRIPTION

The following detailed description and examples set forth preferred materials, components, and procedures used in accordance with the present disclosure. This description and these examples, however, are provided by way of illustration only, and nothing therein shall be deemed to be a limitation upon the overall scope of the present disclosure. The following terms are used in the present disclosure as defined below.

Inter-turn short circuit fault can significantly degrade motor performance and efficiency and may even cause motor failure if not detected promptly. Monitoring of the health state of an induction motor and detection of inter-turn short circuit faults pauses various technical challenges. Existing approaches involve computationally complex operations, require additional sensors or hardware to measure non-electric parameters of the induction motor and/or historical data for training detection models. For example, diagnosing inter-turn short circuit faults based on frequency-domain analysis requires computation of a fast Fourier Transform. Computation of the fast Fourier Transform requires special or advanced processor(s), e.g., a digital signal processor, to perform or execute respective operations efficiently and fast enough to ensure real-time fault detection.

Other approaches may rely on measurements of the temperature, vibration and/or magnetic field of the motor to detect inter-turn short circuit faults. Specific sensors are required to measure the temperature, vibration or magnetic field of the motor. Such sensors are less common within induction motors than electric current sensors. In other words, most of if not all induction motors are usually equipped with electric current sensors or circuitry for measuring electric current fed or input to the induction motor. However, temperature sensors, vibration sensors and/or magnetic field sensors are not commonly integrated into induction motors. Therefore, using measurements of the temperature, vibration and/or magnetic field of the motor to detect inter-turn short circuit faults requires using additional sensors or integrating more sensors in the induction motor.

Another category of fault detection techniques involves using trained machine learning models. Such techniques require a significant amount of historical data for training the machine learning model. Also, depending on the training data used, a trained machine learning model may be suitable for use to detect inter-turn short circuit faults in some type of induction motors but not for some other types of induction motors. To train a machine learning model to be used for various types of induction motors requires the use of historical data associated with the various types of induction motors, which implies a larger training data set and a more complex and more time consuming training process.

Embodiments described herein address the above discussed technical problems and provided improved systems and methods to detect and classify various faults for induction or asynchronous motors based on measured electrical data. Specifically, systems and methods described herein include acquiring, over a time period, a plurality of measurements of three-phase current input to a motor, transforming, using Park transformation, the plurality of measurements of the three-phase current to a plurality of phasors in a two-dimensional space, each measurement of the three-phase current transformed into a corresponding phasor having two-dimensional coordinates in the two-dimensional space, determining an elongation of a shape defined by the plurality of phasors in the two-dimensional space, the elongation of the shape representing a degree to which the shape is stretched in one direction compared to another, and determining, using the elongation of the shape defined by the plurality of phasors in the two-dimensional space, whether the motor suffers from an inter-turn short circuit fault.

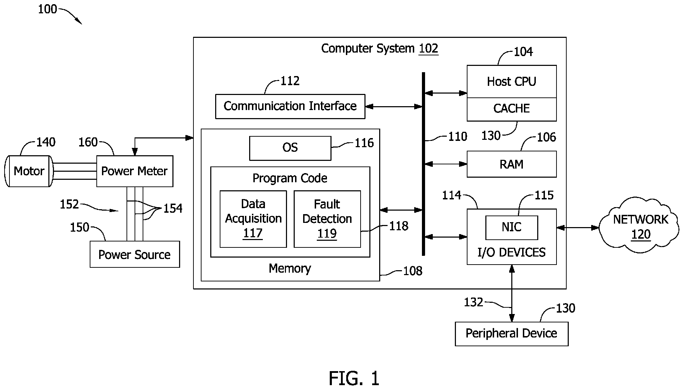

FIG. 1 is a block diagram of a computer environment 100 for inter-turn short circuit fault detection, according to an example embodiment of the current disclosure. In brief overview, the computer environment 100 can include a computer system 102 connected to a communication network 120, a peripheral device 130, an induction motor 140, a power source 150 powering the motor 140 and a measurement device or power meter 160 to measure electric current input to the motor 140.

The computer system 102 can include one or more processors or CPUs 104 coupled to a cache memory 103, and further coupled to a random access memory (RAM) 106 and a memory 108 via a memory bus 110. Cache memory 103 and RAM 106 can be configured to operate in combination with the processor(s) 104. Memory 108 can be a computer-readable memory (e.g., volatile, or non-volatile) that includes at least a memory section storing an OS 116 and a section storing program code 118. In alternative embodiments, one or more sections of memory 108 may be omitted and the corresponding data may be stored remotely. For example, in certain embodiments, program code 118 may be stored remotely on a server or mass-storage device and made available over communication network 120 to the processor(s) 104.

Program code 118 can include computer executable instruction to execute or perform methods described herein or respective operations for detecting inter-turn short circuit faults of the motor 140. For example, the program code 118 can include a data acquisition module 117 for acquiring measurement data from the motor 140 and a fault detection module 119 for detecting operational faults at the motor 140. In general, the data acquisition module 117 and/or the fault detection module 119 can be implemented as software module(s), firmware module(s), hardware module(s) or a combination thereof.

The computer system 102 can include I/O devices 114, which may include, for example, a communication interface such as a network interface controller (NIC) 115, or a peripheral interface for communicating with the peripheral device 130 over a peripheral link 132. I/O devices 114 can include a serial channel controller or other suitable interface, e.g., for updating the program code 118 or accessing data stored in the memory 108. The peripheral device 130 can include a keyboard, a touch screen, a display device, a microphone and/or an audio speaker.

The motor 140 is an induction motor powered by the power source 150. The power source can feed a three-phase current 152, e.g., via three separate electric wires, 154, to the motor 140. The power meter 160 can include a three-phase power meter configured to measure the three-phase current 152 input to the motor 140. The power meter 160 can include a device or circuitry integrated into the motor 140. The power meter 160 can send measured values of the three-phase current 152 to the computer system 102. In some embodiments, the power meter 160 can be configured to measure the three-phase current 152 according to a defined frequency. In some embodiments, the computer system 102 or the processor(s) 104 can control or adjust the measuring frequency of the power meter 160. In some embodiments, the motor 140 and/or the power meter 160 can be viewed as a peripheral device 130.

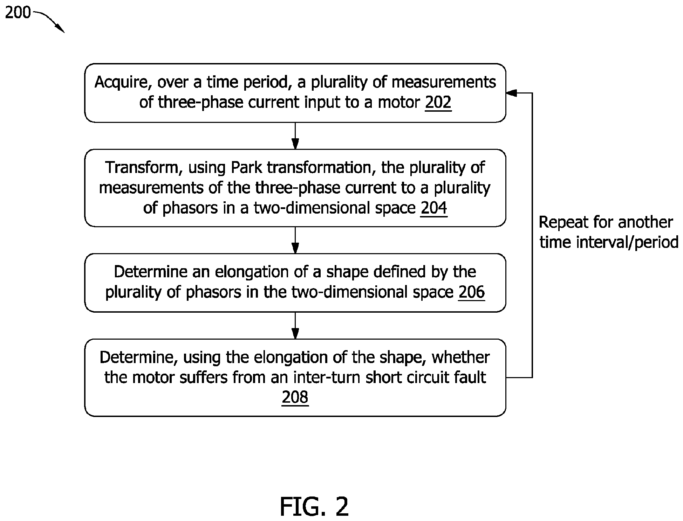

FIG. 2 is a flow chart of a method 200 for inter-turn short circuit fault detection, according to an example embodiment of the current disclosure. In brief overview, the method 200 can include acquiring at 202, over a time period, a plurality of measurements of three-phase current input to a motor, transforming at 204, using Park transformation, the plurality of measurements of the three-phase current to a plurality of phasors in a two-dimensional space, determining at 206 an elongation of a shape defined by the plurality of phasors in the two-dimensional space, and determining at 208, using the elongation of the shape defined by the plurality of phasors in the two-dimensional space, whether the motor suffers from an inter-turn short circuit fault. The method can be performed or executed by the computer system 102 or more generally within the computer environment 100.

The method 200 can include, at 202, the computer system 102, the processor(s) 104 and/or the data acquisition module 117 acquiring, over a time period, a plurality of measurements of the three-phase current 152 fed to the motor 140 by the power source 150. The computer system 102 or the processor(s) 104 can set or define a plurality of time intervals, e.g., consecutive time intervals, referred to herein as fault detection cycles. As discussed in further detail below, the data collected over each fault detection cycle is processed and/or analyzed as a single dataset for the purpose of fault detection.

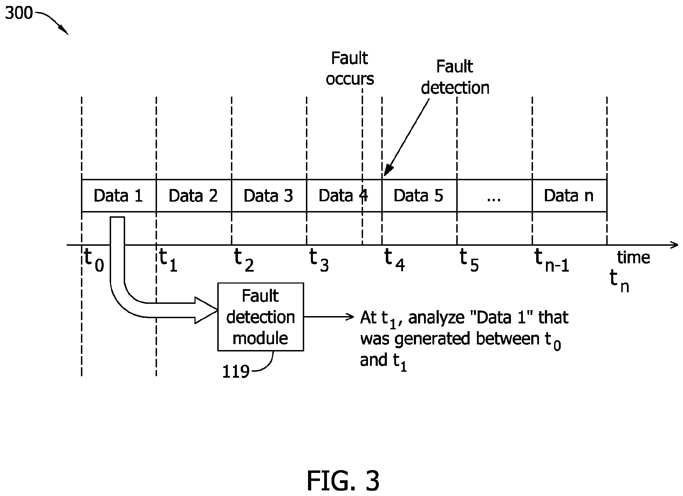

Referring now to FIG. 3, a diagram illustrating a time scheme 300 for fault detection is illustrated, according to an example embodiment of the current disclosure. In some embodiments, the computer system 102 or the processor(s) 104 can determine or define time instances t₀, t₁, t₂, t₃, t₄, t₅, ..., tₙ representing time boundaries of fault detection cycles or time intervals [t₀, t₁), [t₁, t₂), [t₂, t₃), [t₃, t₄), [t₄, t₅), ..., [tₙ₋₁, tₙ). Each of these time intervals represents a separate fault detection cycle. Specifically, the measurements acquired from the motor 140 during each of these time intervals is treated as a dataset sufficient to determine whether a fault occurred within the corresponding time interval. For example, values of the three-phase current 152 measured or acquired during the time interval [t₀, t₁) form dataset 1, values of the three-phase current 152 measured or acquired during the time interval [t₁, t₂) form dataset 2, values of the three-phase current 152 measured or acquired during the time interval [t₂, t₃) form dataset 3, ..., and values of the three-phase current 152 measured or acquired during the time interval [tₙ₋₁, tₙ) form dataset n. At the end of each time interval, the fault detection module 119 can determine whether a fault occurred in the motor 140 in the time interval based on the corresponding dataset. For example, at time instance t₁, the fault detection module 119 can process and/or analyze dataset 1 to determine whether a fault occurred in the motor 140 during the time interval [t₀, t₁).

Referring back to FIG. 2, the method 200 can include the processor(s) 104 or the fault detection module 119 transforming at 204, using Park transformation, the plurality of measurements of the three-phase current 152 to a plurality of phasors in a two-dimensional space. The processor(s) 104 or the fault detection module 119 can transform or convert, using the Park transform, each measurement of the three-phase current 152, e.g., in a dataset i associated with a corresponding fault detection cycle or time interval [tᵢ₋₁, tᵢ] where i is an integer, into a corresponding phasor having two-dimensional or alpha-beta coordinates in the two-dimensional space.

The processor(s) 104 and/or the computer system 102 can determine or define each fault detection cycle or time interval to include a sufficient number of measurements of the three-phase current 152 for fault detection. For example, depending on the measuring frequency of the power meter 160, the processor(s) 104 and/or the computer system 102 can determine or define each fault detection cycle or time interval to be long enough to allow for a sufficient number of samples or values of the three-phase current 152 to be measured by the power meter 160. In some embodiments, the processor(s) 104 and/or the computer system 102 can determine or define each fault detection cycle in terms of a fixed number of measurements of the three-phase current 152. As described in further detail below, the phasors generated using the measured values of the three-phase current 152 in each dataset are expected to form a Park Circle or a full loop which is used to determine whether a fault occurred during the corresponding detection cycle or time interval. As discussed in more detail below, the time interval or the fault detection cycle should satisfy a certain condition to achieve a full or complete loop or Park circle.

At each time instance t, e.g., within a time interval [tᵢ₋₁, tᵢ) where i is an integer, the measured three-phase current 152 can be denoted as (*Iₐ, I_{b}, I_{c}*). The processor(s) 104 or the fault detection module 119 can transform or convert to the three-phase current direct (*Iₐ, I_{b}, I_{c}*) to a phasor having a direct component: ${I}_{d} = \frac{\sqrt{2}}{\sqrt{3}} {I}_{a} - \frac{1}{\sqrt{6}} {I}_{b} - \frac{1}{\sqrt{6}} {I}_{c} ,$ (1) and a quadrature component: ${I}_{q} = \frac{1}{\sqrt{2}} {I}_{b} - \frac{1}{\sqrt{2}} {I}_{c} .$ (2) The phasor of the three-phase current (*Iₐ, I_{b}, I_{c}*) can be represented in the alpha-beta coordinate system as: $I = {I}_{d} + {jI}_{q} ,$ (3)

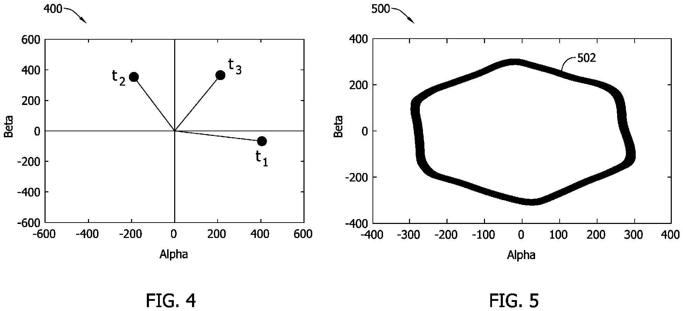

FIG. 4. is a diagram 400 illustrating three vectors or phasors, in the alpha-beta coordinate system, for three-phase current measurements associated with distinct time instances, according to an example embodiment of the current disclosure. The alpha-axis represents the direct component and the beta-axis represent the quadrature component. The phasors shown in FIG. 4 are generated using samples or values of the three-phase current 152 that were measured at time instances τ₁, τ₂, and τ₃, e.g., within some time interval or fault detection cycle [tᵢ₋₁, tᵢ) where i is an integer. In other words, the phasor associated with τ₁ is determined or computed by converting or transforming a first three-phase current measured at time instance τ₁, the phasor associated with τ₂ is determined or computed by converting or transforming, using the Park transform, a first three-phase current measured at time instance τ₂, and the phasor associated with τ₃ is determined or computed by converting a first three-phase current measured at time instance τ₃. the transformation of three sampling points.

The processor(s) 104 or the fault detection module 119 can transform all measurements of the three-phase current acquired within a fault detection cycle or time interval. Specifically, the processor(s) 104 or the fault detection module 119 can transform each measured triplet (*Iₐ, I_{b}, I_{c}*) of the fault detection cycle into a corresponding phasor defined according to equations (1) - (3). The phasors computed or determined using a dataset acquired during a corresponding time interval or fault detection cycle are expected to form a Park circle.

FIG. 5 is a diagram 500 illustrating an example Park circle defined by phasors determined or computed using three-phase current measurements acquired during a corresponding time interval or fault detection cycle, according to an example embodiment of the current disclosure. For the end points of the phasor to form complete loop, e.g., a Park circle, measurements of the three-phase current 152 should span at least one electricity cycle or period. In other words, the time interval or the fault detection cycle *T* can be selected or designed to satisfy $T \geq \frac{1}{f}$*,* where *f* is the frequency of the three-phase current. The loop 502 in FIG. 5 represents end points of phasors determined or computed using measurements of the three-phase current spanning at least one electricity cycle.

Referring back to FIG. 2, the method 200 can include determining at 206 an elongation of a shape defined by the plurality of phasors in the two-dimensional space. The elongation of the shape represents a degree to which the shape is stretched in one direction compared to another. In particular, elongation of the loop or the Park circle defined by the end points of the phasors associated with a corresponding time interval or fault detection cycle *T* is usually indicative of a inter-turn short-circuit fault that occurred during the time interval or fault detection cycle T. Specifically, the inter-turn short-circuit fault causes abnormality that affects the input current to the motor 140. Such abnormality causes the Park circle to be stretched along some direction. Embodiments described herein include quantifying the level of stretching of the Park circle, and using the stretching level to determine whether an inter-tur short-circuit fault has occurred within the fault detection cycle *T.* The stretching level can be quantified using a stretch ratio of the Park circle representing a ratio of a longest dimension or diameter of the Park circle divided by a shortest dimension or diameter of the Park circle.

Various techniques can be used to determine, identify or estimate the longest and shortest dimensions or diameters of the Park circle formed or defined by the end points of the phasors associated with the time interval or the fault detection cycle *T.* In some embodiments, the processor(s) 104 or the fault detection module 119 can divide the Park circle or loop to a plurality of angular sectors evenly, determine or identify a representative phasor for each angular sector of the Park circle or loop, determine pairs of opposite phasors, determine or estimate the longest and shortest dimensions or diameters based on the pairs of opposite phasors, and calculate the stretch ratio using the determined shortest and longest dimensions.

### Divide the Park Circle into angular sectors evenly

The processor(s) 104 and/or the fault detection module 119 can divide the Park circle or the alpha-beta space into a plurality of angular sectors evenly. The angular sectors can have the same angle and can originate at the origin of the alpha-beta space. The phasor *I* defined in equation (3) can be rewritten as: $\vec{{I}_{k}} = \left|{M}_{k}\right| ∠ {ϕ}_{k} ,$ (4) where k is an index of the phasor, |*Mₖ*| is the magnitude of the phasor and *ϕₖ* represents the angle of the phasor *̅I̅ₖ̅*̅. Equation (4) can be viewed as representing the polar coordinates of the phasor *̅I̅ₖ̅*̅ in the alpha-beta space.

The processor(s) 104 and/or the fault detection module 119 can divide the Park circle into N angular sectors with each angular sector having an angle equal to $\frac{360}{N}$ degrees. The set of phasors whose angels are within the range or interval $\left(n∗\frac{360}{N},\left(n+1\right)∗\frac{360}{N}\right]$ can be defined as: ${A}_{n} = \left\{\vec{{I}_{k}}\left|\left(n∗\frac{360}{N}<{ϕ}_{k}\leq \left(n+1\right)∗\frac{360}{N}\right.\right.\right\} ,$ (5) where $n = \left\{1,2,3,…,\frac{N - 1}{2}\right\}$ and N is the total number of angular sectors. The set *Aₙ* represents the set of phasors within the *n^{th}* angular sector spanning between the angels $n ∗ \frac{360}{N}$ and $\left(n+1\right) ∗ \frac{360}{N}$ . Note that by limiting the largest value of *n* to $\frac{N - 1}{2}$, only the angular sectors in the upper half of the Park circle are considered. In other words, the sets *Aₙ* defined in equation (5) for $n = \left\{1,2,3,…,\frac{N - 1}{2}\right\}$ include only the angular sectors in quadrants I and II of the alpha-beta space.

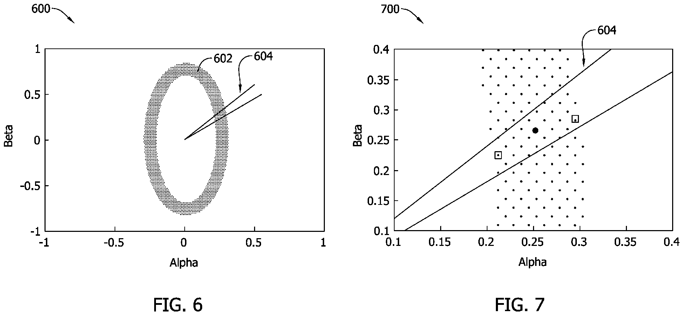

Referring now to FIG. 6, a diagram 600 illustrating phasor end points forming a Park circle 602 and an angular sector 604 is shown, according to an example embodiment of the current disclosure. All the phasors *̅I̅ₖ̅*̅ originate at the origin of the alpha-beta space. The dots forming the Park circle 602 represent the end points of the phasors *̅I̅ₖ̅*̅. Only the end points are presented for visualization in FIG. 6. The angular sector 604 has an angle equal to $\frac{360}{N}$ degrees. Assuming that the angular sector 604 is the *n^{th}* angular sector, the dots within the angular sector 604 represent the end points of the phasors defined by the set of *Aₙ.*

### Determining the representative phasor for each angular sector

For each angular sector 604, e.g., *n^{th}* angular sector defined between the angles n * $\frac{360}{N}$ and $\left(n+1\right) ∗ \frac{360}{N}$ in the upper half of the Park circle 602 or the upper half of the alpha-beta space, the processor(s) 104 and/or the fault detection module 119 can determine a respective representative phasor. In some embodiments, the processor(s) 104 and/or the fault detection module 119 can determine or identify the phasor with the largest magnitude and the phasor with the smallest magnitude in the angular sector 604. The phasor with the maximum or largest magnitude in the *n^{th}* angular sector can be defined as: $\vec{{I}_{n _ E}} = \left\{\vec{{I}_{n _ E}}:\left|\vec{{I}_{n _ E}}\right|\geq \left|\vec{{I}_{k}}\right|for all \vec{{I}_{K}}∈{A}_{n}\right\}$ (6) The phasor with smallest or minimum magnitude in the *n^{th}* angular sector can be defined as: $\vec{{I}_{n _ I}} = \left\{\vec{{I}_{n _ I}}:\left|\vec{{I}_{n _ I}}\right|\leq \left|\vec{{I}_{k}}\right|for all \vec{{I}_{K}}∈{A}_{n}\right\}$ (7) The processor(s) 104 and/or the fault detection module 119 can determine or compute the representative phasor of the *n^{th}* angular sector as the average of the phasors *̅I̅_̅{̅n̅_̅E̅}̅*̅ and *̅I̅_̅{̅n̅_̅I̅}̅*̅: $\vec{{I}_{n _ M}} = \frac{\vec{{I}_{n _ E}} + \vec{{I}_{n _ I}}}{2}$ (8)

Referring now to FIG. 7, a diagram 700 illustrating selection or determination of a representative phasor of the angular sector 604 in FIG. 6 is shown, according to an example embodiment of the current disclosure. The end points of the phasor *̅I̅_̅{̅n̅_̅E̅}̅*̅ having the maximum magnitude and the phasor *̅I̅_̅{̅n̅_̅I̅}̅*̅ having the minimum magnitude in the angular sector 604 are marked as squares (□) in FIG. 7. The end point of the representative phasor *̅I̅_̅{̅n̅_̅M̅}̅*̅, defined as the average of the phasors *̅I̅_̅{̅n̅_̅E̅}̅*̅ and *I̅_̅{̅n̅_̅I̅}̅,* is presented as a solid dot in FIG. 7. The end point of the representative phasor *̅I̅_̅{̅n̅_̅M̅}̅*̅ may not coincide with one of the phasor endpoints in the angular sector 604. The representative phasor *̅I̅_̅{̅n̅_̅M̅}̅*̅ is determined according to equations (6) - (8) to represent all the phasors in the angular sector 604.

In some embodiments, the processor(s) 104 and/or the fault detection module 119 can determine or compute the representative phasor *̅I̅_̅{̅n̅_̅M̅}̅*̅ of an angular sector differently than what is described in equations (6) - (8). For example, the processor(s) 104 and/or the fault detection module 119 can determine or compute the representative phasor *̅I̅_̅{̅n̅_̅M̅}̅*̅ of the *n^{th}* angular sector as the average of all phasors within the angular sector, i.e., $\vec{{I}_{n _ M}} = \frac{1}{{M}_{n}} \sum \vec{{I}_{K}} , \vec{{I}_{K}} ∈ {A}_{n}$ (9) where *Mₙ* represents the total number of phasors in the *n^{th}* angular sector.

In some embodiments, the processor(s) 104 and/or the fault detection module 119 can determine the representative phasor *̅I̅_̅{̅n̅_̅M̅}̅*̅ to be equal to the phasor *̅I̅_̅{̅n̅_̅E̅}̅*̅ having the maximum magnitude within the angular sector. In some embodiments, the processor(s) 104 and/or the fault detection module 119 can determine the representative phasor *̅I̅_̅{̅n̅_̅M̅}̅*̅ to be equal to the phasor *̅I̅_̅{̅n̅_̅I̅}̅*̅ having the minimum magnitude within the angular sector. In some embodiments, the processor(s) 104 and/or the fault detection module 119 can determine the representative phasor *̅I̅_̅{̅n̅_̅M̅}̅*̅ to be equal to the median of the phasors *̅I̅_̅{̅n̅_̅E̅}̅*̅ and *I̅_̅{̅n̅_̅I̅}̅.*

### Determining phasor pairs

For every *I̅_̅{̅n̅_̅M̅}̅,* the processor(s) 104 and/or the fault detection module 119 can determine a corresponding paring phasor *̅I̅_̅{̅n̅_̅P̅}̅*̅ on the other half of the Park circle or in an angular sector opposite to the *n^{th}* angular sector. To determine the paring phasor *I̅_̅{̅n̅_̅P̅}̅,* the processor(s) 104 and/or the fault detection module 119 can determine or identify an angular sector that is opposite to the *n^{th}* angular sector, and determine a representative phasor of the opposite angular sector in a similar way as the representative phasor of the *n^{th}* angular sector.

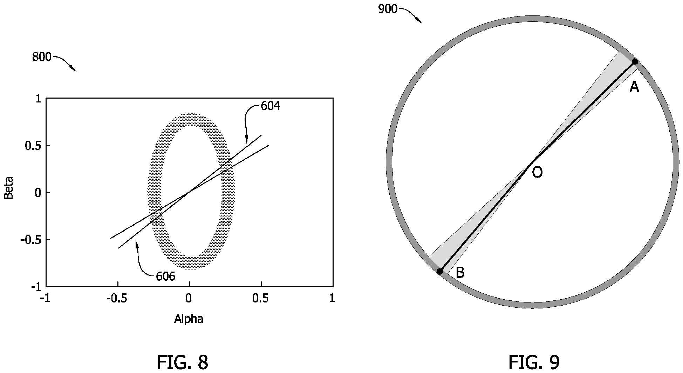

FIG. 8 is a diagram 800 illustrating the angular sector 604 and a corresponding opposite angular sector 606, according to an example embodiment of the current disclosure. The opposite angular sector 606 is diagonally opposite to the angular sector 604. The processor(s) 104 and/or the fault detection module 119 can determine or identify the representative phasor for the opposite angular sector 606 by applying equations (6) - (8) or any of the other techniques described above to phasors within the opposite angular sector 606. It is to be noted that the same technique for determining a representative phasor is applied to all angular sectors, including opposite angular sectors.

FIG. 9 is a diagram 900 illustrating a representative phasor *̅O̅A̅*̅ for the angular sector 604 and the corresponding pairing phasor *̅O̅B̅*̅ of the angular sector 606 opposite to the angular sector 604, according to an example embodiment of the current disclosure. As discussed above, the representative phasor *̅O̅A̅*̅ can be determined by applying equations (6) - (8), equation (9) or any of the other representative phasor techniques described above to the phasors within the angular sector 604. The processor(s) 104 and/or the fault detection module 119 can apply the same technique or approach used for phasors within the angular sector 604 to the phasors within the opposite angular sector 606 to determine the representative phasor *̅O̅B̅*̅

It is to be noted that the representative phasor *̅O̅A̅*̅ and the corresponding paring phasor *̅O̅B̅*̅ may not be necessarily diagonally opposite to one another. In other words, the angle between the phasors *̅O̅A̅*̅ and *OB* may not be equal to 180 degrees. This is true for every representative phasor *̅I̅_̅{̅n̅_̅M̅}̅*̅ and the corresponding pairing phasor *I̅_̅{̅n̅_̅P̅}̅.* The pair of phasors *̅I̅_̅{̅n̅_̅M̅}̅*̅ and *̅I̅_̅{̅n̅_̅P̅}̅*̅ may or may not form a 180-degrees angle.

### Calculating the stretch ratio

The above discussed approach leads to $\frac{N}{2}$ pairs of phasors when the Park circle is divided into N angular sectors. The processor(s) 104 and/or the fault detection module 119 can determine or compute for each pair of phasors (*I̅_̅{̅n̅_̅M̅}̅, I̅_̅{̅n̅_̅P̅}̅*) the distance between the end points of the two phasors as: ${d}_{n} = \left|\vec{{I}_{n _ P}}-\vec{{I}_{n _ M}}\right|$ (10) The processor(s) 104 and/or the fault detection module 119 can determine the minimum distance *dₘᵢₙ* and the maximum distance *dₘₐₓ* among all distances *dₙ.* The minimum distance *dₘᵢₙ* can be viewed as an estimate of the shortest or minimum dimension of diameter of the Park circle and *dₘₐₓ* can be viewed as an estimate of the longest or maximum dimension or diameter of the Park circle. The processor(s) 104 and/or the fault detection module 119 can determine or compute the stretch ratio of the Park circle as the ratio of *dₘₐₓ* divided by *dₘᵢₙ*: $r = \frac{{d}_{max}}{{d}_{min}}$ (11)

Referring back to FIG. 2, the method 200 can include determining at 208, using the elongation of the shape defined by the plurality of phasors in the two-dimensional space, whether the motor suffers from an inter-turn short circuit fault. For example, the processor(s) 104 and/or the fault detection module 119 can compare the stretch ratio *r* to a defined threshold. The processor(s) 104 and/or the fault detection module 119 can detect an inter-turn short-circuit fault upon determining that the stretch ratio *r* exceeds the threshold, otherwise determine that no inter-turn short-circuit fault occurred with the fault detection cycle. The threshold value can be determined based on experimental data. In some embodiments, a trained machine learning model can be used to detect inter-turn short-circuit faults. The trained machine learning model can be configured to receive the elongation, e.g., stretch ratio r, as input and provide as output an indication of whether the motor suffers from an inter-turn short circuit fault.

Upon detecting a fault, the processor(s) 104 and/or the fault detection module 119 can output an alert signal indicative of the inter-turn short circuit fault, e.g., via the network 120 or the peripheral device 130, switch off the motor 140, and/or or actuate one or more processes to further check for the inter-turn short circuit fault. For example, the processor(s) 104 and/or the fault detection module 119 can use other fault detection techniques to confirm or decline the occurrence of an inter-turn short-circuit fault.

If no fault is detected, the computer system 102 and/or the processor(s) 104 can repeat the operations 202 - 208 for a next time interval or fault detection cycle, e.g., as indicated in FIG. 2. The computer system 102 and/or the processor(s) 104 can repeat the operations 202 - 208 even if a fault was detected, e.g., to confirm or decline the detection of the fault.

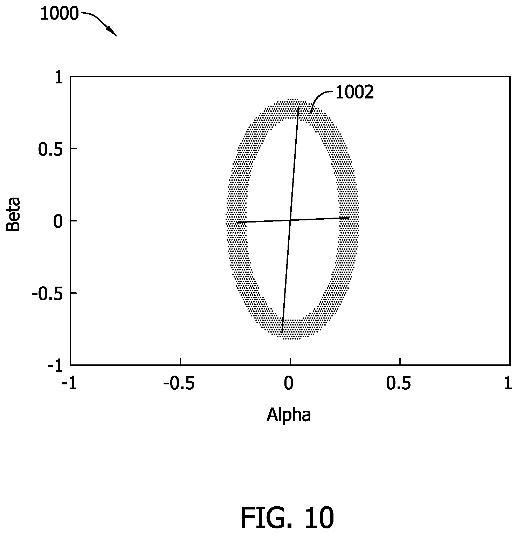

FIG. 10 is a diagram 1000 illustrating a stretched Park circle 1002 and the corresponding longest and shortest dimensions, according to an example embodiment of the current disclosure. The Park circle 1002 corresponds to data from a motor 140 with inter-turn short-circuit fault. The phasors forming the Park circle 1002 were analyzed according to equations (4) - (8) and (10) to identify the shortest and longest dimensions of the Parke circle 1002. Using equation (11), the stretch ratio was determined to be equal to 3.18. An inter-tom short-circuit fault was detected based on the stretch ratio value, which is significantly larger than 1, i.e., the stretch ratio of a perfect circle.

The fault detection approach described above in relation to equations (1) - 8 and (10) - (11) can be implemented as Algorithm 1 below:

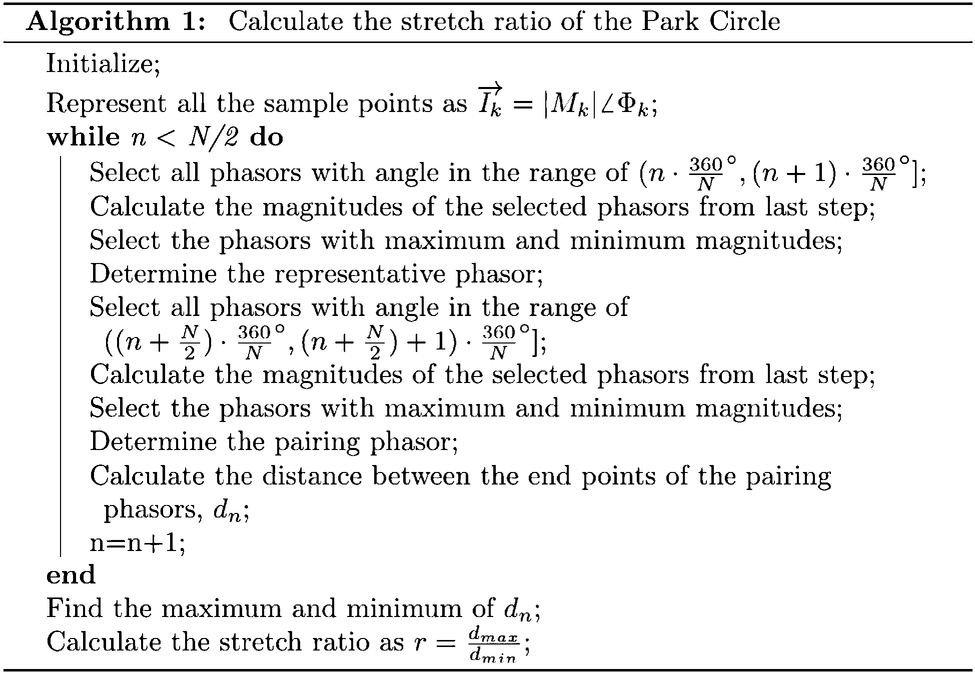

It is to be noted that other approaches can be used to determine the shortest and longest dimensions of the Park circle. For example, the processor(s) 104 and/or the fault detection module 119 can employ image processing and/or computer vision techniques to determine an interior envelope and/or an exterior envelope of the endpoints of all the phasors. Such techniques can include image filtering, image segmentation and/or meshes of phasor end points, among other techniques. The processor(s) 104 and/or the fault detection module 119 can determine an intermediate envelope between the interior envelope and the exterior envelop. In some embodiments, the processor(s) 104 and/or the fault detection module 119 can use the shortest dimension and the longest dimension of the interior envelope to compute the stretch ratio *r* of the Park circle. In some embodiments, the processor(s) 104 and/or the fault detection module 119 can use the shortest dimension and the longest dimension of the exterior envelope to compute the stretch ratio *r* of the Park circle. In some embodiments, the processor(s) 104 and/or the fault detection module 119 can use the shortest dimension and the longest dimension of the intermediate envelope to compute the stretch ratio r of the Park circle.

The embodiments described above provide or allow various technical advantages. First, the methods or techniques described herein are faster and computationally simpler than existing inter-turn short-circuit fault detection approaches. The operations or techniques discussed above involve relatively simple and basic mathematical functions, such as addition, subtraction, multiplication, division, comparison, max, min, square and square root. For example, the embodiments described herein are faster and computationally simpler than frequency-domain analysis which involves the computation of the FFT or machine learning methods.

Second, the embodiments described herein rely on measurements of the three-phase current. As such, the fault detection can be performed without requiring additional sensors, such as temperature sensors, vibration sensors and/or magnetic sensors.

Third, since most induction motors already include circuitry or hardware to measure three-phase current and include circuitry or hardware to implement operations or methods described herein, the embodiments described herein can be implemented by installing software or scripts to execute methods described herein in the motor 140. Such implementation can be achieved with low marginal cost.

Finally, embodiments described herein may not require historical data or events. The fault detection relies only on real-time three-phase current measurement generated by the motor 140 and/or the power meter 160.

Embodiments described herein can detect inter-turn short-circuit faults independently, or can be used in combination with other existing detection methods or approaches. For example, another detection approach can be used to crosscheck detection decisions output by embodiments described herein. The computer system 102 and/or the processor(s) 104 may trigger a restoration process responsive to a detected fault. For instance, embodiments described herein can be implemented as part of a motor control/protection/restoration system which needs fault detection, especially for inter-turn short-circuit fault.

The various aspects illustrated by logical blocks, modules, circuits, processes, algorithms, and algorithm steps described above may be implemented as electronic hardware, software, or combinations of both. Certain disclosed components, blocks, modules, circuits, and steps are described in terms of their functionality, illustrating the interchangeability of their implementation in electronic hardware or software. The implementation of such functionality varies among different applications given varying system architectures and design constraints. Although such implementations may vary from application to application, they do not constitute a departure from the scope of this disclosure.

Aspects of embodiments implemented in software may be implemented in program code, application software, application programming interfaces (APIs), firmware, middleware, microcode, hardware description languages (HDLs), or any combination thereof. A code segment or machine-executable instruction may represent a procedure, a function, a subprogram, a routine, a subroutine, a module, a software package, a class, or any combination of instructions, data structures, or program statements. A code segment may be coupled to, or integrated with, another code segment or an electronic hardware by passing or receiving information, data, arguments, parameters, memory contents, or memory locations. Information, arguments, parameters, data, etc. may be passed, forwarded, or transmitted via any suitable means including memory sharing, message passing, token passing, network transmission, etc.

The actual software code or specialized control hardware used to implement these systems and methods is not limiting of the claimed features or this disclosure. Thus, the operation and behavior of the systems and methods were described without reference to the specific software code being understood that software and control hardware can be designed to implement the systems and methods based on the description herein.

When implemented in software, the disclosed functions may be embodied, or stored, as one or more instructions or code on or in memory. In the embodiments described herein, memory includes non-transitory computer-readable media, which may include, but is not limited to, media such as flash memory, a random access memory (RAM), read-only memory (ROM), erasable programmable read-only memory (EPROM), electrically erasable programmable read-only memory (EEPROM), and non-volatile RAM (NVRAM). As used herein, the term "non-transitory computer-readable media" is intended to be representative of any tangible, computer-readable media, including, without limitation, non-transitory computer storage devices, including, without limitation, volatile and non-volatile media, and removable and non-removable media such as a firmware, physical and virtual storage, CD-ROM, DVD, and any other digital source such as a network, a server, cloud system, or the Internet, as well as yet to be developed digital means, with the sole exception being a transitory propagating signal. The methods described herein may be embodied as executable instructions, e.g., "software" and "firmware," in a non-transitory computer-readable medium. As used herein, the terms "software" and "firmware" are interchangeable and include any computer program stored in memory for execution by personal computers, workstations, clients, and servers. Such instructions, when executed by a processor, configure the processor to perform at least a portion of the disclosed methods.

As used herein, an element or step recited in the singular and proceeded with the word "a" or "an" should be understood as not excluding plural elements or steps unless such exclusion is explicitly recited. Furthermore, references to "one embodiment" of the disclosure or an "exemplary" or "example" embodiment are not intended to be interpreted as excluding the existence of additional embodiments that also incorporate the recited features. Likewise, limitations associated with "one embodiment" or "an embodiment" should not be interpreted as limiting to all embodiments unless explicitly recited.

Disjunctive language such as the phrase "at least one of X, Y, or Z," unless specifically stated otherwise, is generally intended, within the context presented, to disclose that an item, term, etc. may be either X, Y, or Z, or any combination thereof (e.g., X, Y, and/or Z). Likewise, conjunctive language such as the phrase "at least one of X, Y, and Z," unless specifically stated otherwise, is generally intended, within the context presented, to disclose at least one of X, at least one of Y, and at least one of Z.

The disclosed systems and methods are not limited to the specific embodiments described herein. Rather, components of the systems or steps of the methods may be utilized independently and separately from other described components or steps.

This written description uses examples to disclose various embodiments, which include the best mode, to enable any person skilled in the art to practice those embodiments, including making and using any devices or systems and performing any incorporated methods. The patentable scope is defined by the claims and may include other examples that occur to those skilled in the art. Such other examples are intended to be within the scope of the claims if they have structural elements that do not differ from the literal language of the claims, or if they include equivalent structural elements with insubstantial differences form the literal language of the claims.

## Claims

1. A system for inter-turn short circuit fault detection, the system comprising:
one or more processors; and
a memory storing computer instructions, the computer instructions when executed by the one or more processors cause the one or more processors to:
acquire, over a time period, a plurality of measurements of three-phase current input to a motor;
transform, using Park transformation, the plurality of measurements of the three-phase current to a plurality of phasors in a two-dimensional space, each measurement of the three-phase current transformed into a corresponding phasor having two-dimensional coordinates in the two-dimensional space;
determine an elongation of a shape defined by the plurality of phasors in the two-dimensional space, the elongation of the shape representing a degree to which the shape is stretched in one direction compared to another; and
determine, using the elongation of the shape defined by the plurality of phasors in the two-dimensional space, whether the motor suffers from an inter-turn short circuit fault.

2. The system of claim 1, wherein to determine the elongation the one or more processors are configured to:
determine a longest dimension of the shape defined by the plurality of phasors in the two-dimensional space;
determine a shortest dimension of the shape defined by the plurality of phasors in the two-dimensional space; and
compute the elongation as a ratio of the longest dimension to the shortest dimension, particularly wherein the one or more processors are configured to detect that the motor suffers from the inter-turn short circuit fault upon determining that the ratio of the longest dimension to the shortest dimension exceeds a threshold value.

3. The system of claim 1, wherein the one or more processors are configured to:
divide the shape defined by the plurality of phasors in the two-dimensional space into a plurality of angular sectors;
determine, for each angular sector of the plurality of angular sectors, a representative phasor of the angular sector;
arrange the representative phasors into pairs, each pair of representative phasors corresponding to a pair of diagonally opposite angular sectors;
determine, for each pair of representative phasors, a distance between end points of the pair of representative phasors;
determine, among all pairs of representative phasors, a first pair of representative phasors with a shortest distance between respective end points and a second pair of representative phasors with a longest distance between respective end points; and
determine the elongation as a ratio of the longest distance to the shortest distance.

4. The system of claim 3, wherein the one or more processors are configured to determine that the motor suffers from the inter-turn short circuit fault upon determining that the ratio of the longest distance to the shortest distance exceeds a threshold value, or wherein the one or more processors are configured to determine, for each angular sector, the representative phasor of the angular sector as:
an average phasor of the angular sector;
a median phasor of the angular sector;
a maximum phasor of the angular sector; or
a minimum phasor of the angular sector.

5. The system of claim 3, wherein the one or more processors are configured to:
determine, for each angular sector, a first phasor having a largest magnitude in the angular sector and a second phasor having a smallest magnitude in the angular sector; and
determine the representative phasor of the angular sector as an average of the first phasor and the second phasor.

6. The system of claim 1, wherein the one or more processors are configured to:
acquire, over a second time period, a second plurality of measurements of three-phase current input to the motor;
transform, using the Park transformation, the second plurality of measurements of the three-phase current to a second plurality of phasors in the two-dimensional space;
determine a second elongation of a second shape defined by the second plurality of phasors in the two-dimensional space; and
determine, using the second elongation of the second shape defined by the second plurality of phasors in the two-dimensional space, whether the motor suffers from the inter-turn short circuit fault.

7. The system of claim 1, wherein the one or more processors are configured, upon determining that the motor suffers from the inter-turn short circuit fault, to perform at least one of:
output an alert signal indicative of the inter-turn short circuit fault;
switch off the motor; or
actuate one or more processes to further check for the inter-turn short circuit fault; or wherein the one or more processors are configured to employ a trained machine learning model to determine whether the motor suffers from an inter-turn short circuit fault, the trained machine learning model is configured to receive the elongation as input and provide as output an indication of whether the motor suffers from an inter-turn short circuit fault.

8. A method for inter-turn short circuit fault detection, the method comprising:
acquiring, over a time period, a plurality of measurements of three-phase current input to a motor;
transforming, using Park transformation, the plurality of measurements of the three-phase current to a plurality of phasors in a two-dimensional space, each measurement of the three-phase current transformed into a corresponding phasor having two-dimensional coordinates in the two-dimensional space;
determining an elongation of a shape defined by the plurality of phasors in the two-dimensional space, the elongation of the shape representing a degree to which the shape is stretched in one direction compared to another; and
determining, using the elongation of the shape defined by the plurality of phasors in the two-dimensional space, whether the motor suffers from an inter-turn short circuit fault.

9. The method of claim 8, wherein determining the elongation includes:
determining a longest dimension of the shape defined by the plurality of phasors in the two-dimensional space;
determining a shortest dimension of the shape defined by the plurality of phasors in the two-dimensional space; and
computing the elongation as a ratio of the longest dimension to the shortest dimension, particularly comprising detecting that the motor suffers from the inter-turn short circuit fault upon determining that the ratio of the longest dimension to the shortest dimension exceeds a threshold value.

10. The method of claim 8, comprising:
dividing the shape defined by the plurality of phasors in the two-dimensional space into a plurality of angular sectors;
determining, for each angular sector of the plurality of angular sectors, a representative phasor of the angular sector;
arranging the representative phasors into pairs, each pair of representative phasors corresponding to a pair of diagonally opposite angular sectors;
determining, for each pair of representative phasors, a distance between end points of the pair of representative phasors;
determining, among all pairs of representative phasors, a first pair of representative phasors with a shortest distance between respective endpoints and a second pair of representative phasors with a longest distance between respective endpoints; and
determining the elongation as a ratio of the longest distance to the shortest distance.

11. The method of claim 10, comprising determining that the motor suffers from the inter-turn short circuit fault upon determining that the ratio of the longest distance to the shortest distance exceeds a threshold value, or comprising determining, for each angular sector, the representative phasor of the angular sector as:
an average phasor of the angular sector;
a median phasor of the angular sector;
a maximum phasor of the angular sector; or
a minimum phasor of the angular sector.

12. The method of claim 10, comprising:
determining, for each angular sector, a first phasor having a largest magnitude in the angular sector and a second phasor having a smallest magnitude in the angular sector; and
determining the representative phasor of the angular sector as an average of the first phasor and the second phasor.

13. The method of claim 8, comprising:
acquiring, over a second time period, a second plurality of measurements of three-phase current input to the motor;
transforming, using the Park transformation, the second plurality of measurements of the three-phase current to a second plurality of phasors in the two-dimensional space;
determining a second elongation of a second shape defined by the second plurality of phasors in the two-dimensional space; and
determining, using the second elongation of the second shape defined by the second plurality of phasors in the two-dimensional space, whether the motor suffers from the inter-turn short circuit fault.

14. The method of claim 8, comprising, upon determining that the motor suffers from the inter-turn short circuit fault, performing at least one of:
outputting an alert signal indicative of the inter-turn short circuit fault;
switching off the motor; or
actuating one or more processes to further check for the inter-turn short circuit fault.

15. The method of claim 8, comprising:
employing a trained machine learning model to determine whether the motor suffers from an inter-turn short circuit fault, the trained machine learning model is configured to receive the elongation as input and provide as output an indication of whether the motor suffers from an inter-turn short circuit fault.
